# DEMANDE DE BREVET EUROPEEN

(11) **EP 3 070 481 A1**
(43) Date de publication de la demande: **21.09.2016**
(21) Numéro de dépôt: 15305398.8
(22) Date de dépôt: 19.03.2015
(51) Int. Cl.: G01R 15/16, G01R 29/12

(54) **Capteur capacitif**

(71) Demandeur: Nexans, 75008 Paris (FR)
(72) Inventeur: De Ridder, Eduard, 9310 Herdersem (BE); Vlaeyen, Bart Louis, 9320 Erembodegem (BE)
(74) Mandataire: Lenne, Laurence

(57) **Abrégé**

L'invention concerne un capteur capacitif s'étendant le long d'un axe longitudinal (A-A) et comportant un ensemble de deux électrodes, une électrode source (1) apte à être reliée à une barre de tension et une électrode de mesure du champ électrique (2) faisant face à l'électrode source le long de cet axe longitudinal (A - A) à une distance déterminée, ledit ensemble de deux électrodes étant disposé au moins partiellement à l'intérieur d'un ensemble de blindage, composé d'un élément de blindage tubulaire (3) s'étendant le long de cet axe longitudinal (A-A) et d'une chambre blindée (8), l'électrode source (1) étant noyée dans un isolateur (4) de matériau diélectrique et ladite chambre blindée étant extérieure audit isolateur (1).

Selon l'invention, ladite électrode de mesure est constituée d'une couche de matériau conducteur (2) appliquée sur une surface dudit isolateur (4).

## Description

L'invention concerne un capteur capacitif s'étendant le long d'un axe longitudinal et comportant un ensemble de deux électrodes, une électrode source apte à être reliée à une barre de tension et une électrode de mesure du champ électrique faisant face à l'électrode source le long de cet axe longitudinal à une distance déterminée, ledit ensemble de deux électrodes étant disposé au moins partiellement à l'intérieur d'un ensemble de blindage, composé d'un élément de blindage tubulaire s'étendant le long de cet axe longitudinal et d'une chambre blindée, l'électrode source étant noyée dans un isolateur de matériau diélectrique et ladite chambre blindée étant extérieure audit isolateur.

Le document de brevet EP 2 347 270 décrit un capteur capacitif s'étendant le long d'un axe longitudinal et comportant une électrode source apte à être reliée à une barre de tension et une électrode de mesure du champ électrique faisant face à l'électrode source le long de cet axe longitudinal à une distance déterminée, ces deux électrodes étant disposées à l'intérieur d'une paroi de blindage tubulaire formant une première chambre blindée de cage de Faraday s'étendant le long de cet axe longitudinal.

L'électrode de mesure est fixée au moyen d'une vis de fixation traversant une paroi d'une seconde chambre blindée avec interposition d'une bague d'écartement et au moins un élément d'espacement, l'extrémité de cette vis étant vissée dans l'électrode de mesure.

Ces éléments sont noyés dans une masse de matériau diélectrique de moyenne densité formant un isolateur cylindrique.

Le capteur comporte également dans la seconde chambre blindée un circuit électronique de traitement électriquement connecté à l'électrode de mesure, par l'intermédiaire de la vis de fixation.

Ce type de capteur capacitif pose les problèmes techniques suivants.

La fabrication de ce capteur capacitif est complexe, fragile et coûteuse.

En particulier, lors de cette fabrication, la paroi de blindage tubulaire et les électrodes métalliques ainsi que toutes les autres pièces internes perturbent l'écoulement du matériau diélectrique injecté durant le moulage de l'isolateur et tendent à entraîner la création d'espaces vides, en particulier dans une configuration de petit encombrement. Ces espaces vides perturbent la tenue électrique et la fiabilité du capteur.

Par ailleurs, les différentes pièces assurant la fixation de l'électrode de mesure entrainent une accumulation des différentes tolérances de dimensionnement de ces pièces et donc un positionnement précis difficile de cette électrode et une réalisation difficile de la distance déterminée entre l'électrode source et l'électrode de mesure. De plus, il existe des risques de déformations de ces pièces. Il en résulte la nécessité d'une compensation durant la calibration du capteur.

L'invention résout ces problèmes en proposant un capteur capacitif de fabrication et d'utilisation plus aisée et de meilleure fiabilité.

Pour ce faire, l'invention propose un capteur capacitif s'étendant le long d'un axe longitudinal et comportant un ensemble de deux électrodes, une électrode source apte à être reliée à une barre de tension et une électrode de mesure du champ électrique faisant face à l'électrode source le long de cet axe longitudinal à une distance déterminée, ledit ensemble de deux électrodes étant disposé au moins partiellement à l'intérieur d'un ensemble de blindage, composé d'un élément de blindage tubulaire s'étendant le long de cet axe longitudinal et d'une chambre blindée, l'électrode source étant noyée dans un isolateur de matériau diélectrique et ladite chambre blindée étant extérieure audit isolateur, capteur capacitif caractérisé en ce que ladite électrode de mesure est constituée d'une couche de matériau conducteur appliquée sur une surface dudit isolateur.

Cette couche de matériau conducteur peut être réalisée par métallisation ou peinture conductrice et l'ensemble de blindage est mis à la terre.

L'agencement conforme à l'invention réduit de façon notable la dimension d'encombrement d'un tel capteur.

Selon un mode de réalisation préféré, ladite couche de matériau conducteur est de forme arrondie en section longitudinale, ladite surface de l'isolateur comportant une partie centrale convexe.

Avantageusement, ladite couche de matériau conducteur présente un bord arrondi en section longitudinale, ladite partie centrale convexe de ladite surface de l'isolateur étant bordée d'une partie annulaire concave en section longitudinale.

La contrainte électrique est ainsi minimisée et cette forme peut facilement être obtenue sur l'isolateur par une forme correspondante du moule de moulage de l'isolateur qui peut être fabriqué avec de très faibles tolérances.

De préférence, ladite électrode source présente une extrémité libre faisant face à l'électrode de mesure et constituée d'une tige de diamètre compris entre 10 et 90% du diamètre dudit élément de blindage.

Le diamètre de ladite tige de l'extrémité libre de ladite électrode source est de préférence d'environ 40% du diamètre dudit élément de blindage.

Grâce à la forme de l'électrode source et à son diamètre de tige relativement grand, la capacité détectée est relativement augmentée et il en résulte une précision de mesure améliorée. Il en résulte également des champs électriques plus réduits et la possibilité d'appliquer ce capteur capacitif à des hautes tensions en particulier avec une configuration d'encombrement relativement petit.

Le capteur comporte avantageusement un circuit électronique de traitement électriquement connecté à ladite couche de matériau conducteur.

Ledit circuit électronique est de préférence disposé dans ladite chambre blindée externe audit isolateur.

Ledit circuit électronique de traitement est avantageusement électriquement connecté à ladite couche de matériau conducteur par un élément élastique conducteur.

Ledit élément élastique peut être un ressort hélicoïdal dont une extrémité est en appui sur ladite couche conductrice.

Cet agencement à ressort facilite grandement le montage du dispositif. Il assure également la possibilité de démonter et remplacer le circuit électronique de façon aisée.

De préférence, ledit élément de blindage tubulaire est une paroi de blindage noyée dans le matériau diélectrique de l'isolateur.

Cette paroi de blindage tubulaire peut être supportée par au moins deux tenons surmoulés dans ledit isolateur.

Lors de l'injection du matériau diélectrique formant l'isolateur, la paroi de blindage est ainsi maintenue en place.

Ledit circuit électronique peut être disposé dans une cavité agencée à l'intérieur de ladite paroi de blindage tubulaire.

Ladite cavité peut être cylindrique centrée sur ledit axe longitudinal et disposée à l'intérieur de ladite paroi de blindage tubulaire.

Ladite paroi de blindage tubulaire peut être en treillis métallique.

Grâce à l'invention, il est obtenu une augmentation de la capacité électrique d'environ 39% et une diminution de la contrainte électrique maximale d'environ 48% à dimensionnement égal. Le capteur conforme à l'invention peut ainsi être utilisé sans problème pour des hautes tensions.

L'invention est décrite ci-après plus en détail à l'aide de figures ne représentant que des modes de réalisation préférés de l'invention.
Les figures 1 et 2 sont des vues en perspective partielle et en coupe longitudinale d'un capteur capacitif conforme à un premier mode de réalisation de l'invention.
Les figures 3 et 4 sont des vues en perspective partielle et en coupe longitudinale d'un capteur capacitif conforme à un second mode de réalisation de l'invention.

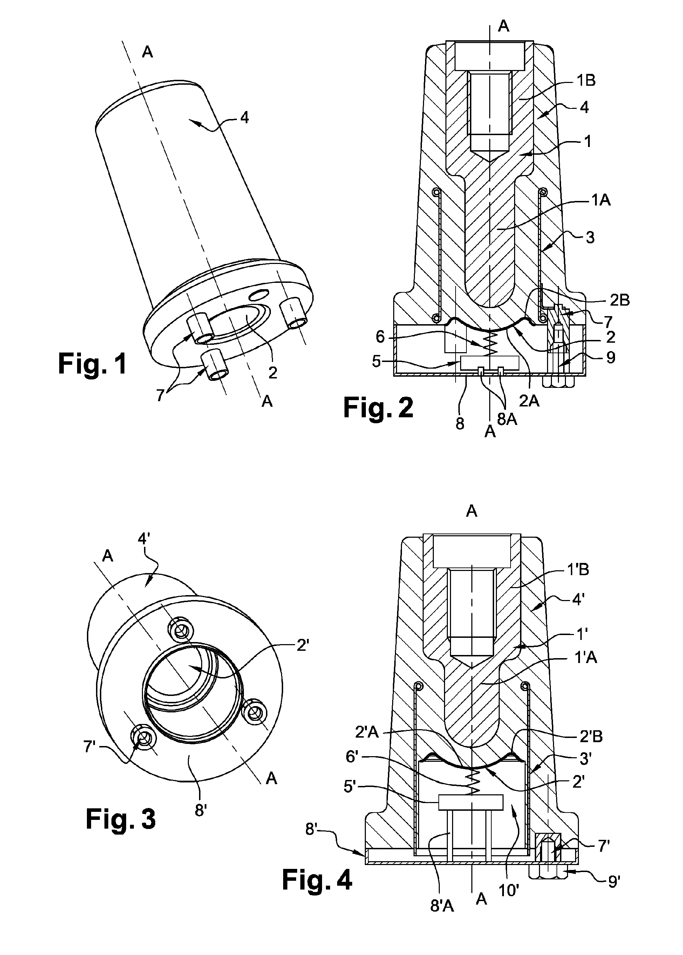

Comme représenté sur les figures 1 et 2, un capteur capacitif s'étendant le long d'un axe longitudinal A - A comporte un ensemble de deux électrodes, une électrode source 1 en matière conducteur, de préférence métallique, apte à être reliée à une barre de tension et une électrode de mesure du champ électrique 2 faisant face à l'électrode source 1 le long de cet axe longitudinal A - A à une distance déterminée, l'ensemble de deux électrodes étant disposé au moins partiellement à l'intérieur d'une paroi de blindage tubulaire ouverte 3, de préférence en treillis métallique, s'étendant le long de cet axe longitudinal A - A.

L'électrode source 1 et la paroi de blindage 3 sont noyées dans un isolateur de matériau diélectrique 4, de préférence de la résine époxy ou du polyuréthane. Cet isolateur 4 est ici de forme tronconique mais peut également être cylindrique à section constante.

Selon l'invention, l'électrode de mesure 2 est constituée d'une couche de matériau conducteur, appliquée sur une surface extérieure de l'isolateur 4 et réalisé par métallisation ou peinture conductrice, dont la résistivité est inférieure à 10⁴ Ω.cm.

Selon ce premier mode de réalisation, cette couche de matériau conducteur 2 est disposée sensiblement à l'extrémité de la paroi de blindage tubulaire 3 de façon opposée à l'électrode source 1.

La couche de matériau conducteur est un disque de forme arrondie 2A en section longitudinale, la surface extérieure de l'isolateur 4 comportant une partie centrale convexe, et présente un bord arrondi 2B en section longitudinale, cette partie centrale convexe de la surface extérieure de l'isolateur étant bordée d'une partie annulaire concave en section longitudinale.

L'électrode source 1 présente une extrémité libre faisant face à l'électrode de mesure 2 et est constituée d'une tige cylindrique 1A à extrémité demi-sphérique ou arrondie et de diamètre compris entre 10% et 90% du diamètre de la paroi de blindage tubulaire et de préférence de l'ordre d'environ 40% du diamètre de la paroi du blindage. Elle comporte également une partie 1B de connexion mécanique et électrique à une barre de tension qui est cylindrique de diamètre supérieur.

Le dispositif comporte également un circuit électronique de traitement 5 électriquement connecté à la couche de matériau conducteur 2.

Ce circuit électronique de traitement 5 est électriquement connecté à la couche de matériau conducteur 2 par un élément élastique conducteur 6, constitué ici par un ressort hélicoïdal, dont une extrémité est en appui sur la couche de matériau conducteur 2, l'autre extrémité étant connecté à une piste adéquate du circuit électronique de traitement 5.

La paroi de blindage tubulaire 3 est supportée par au moins deux tenons 7 surmoulés dans l'isolateur 4, de préférence par trois tenons 7 répartis régulièrement autour de l'axe longitudinal A - A.

Selon ce premier mode de réalisation représenté sur les figures 1 et 2, le circuit électronique 5 est disposé dans une chambre blindée 8 externe à l'isolateur 4 et formée d'une cuve ouverte, connectée à la paroi de blindage 3 et mise à la terre. Le circuit électronique 5 est posé sur un support 8A posé sur la paroi de fond de cette chambre blindée 8. Le ressort 6 est ainsi comprimé entre le circuit électronique 5 et la couche de matériau conducteur 2. L'ensemble est fixé avec la chambre blindée 8 au moyen d'une vis 9 vissée dans chaque tenon 7. La seconde chambre 8 n'est pas représentée sur la figure 1.

Les figures 3 et 4 représentent un autre mode de réalisation.

Un capteur capacitif s'étendant le long d'un axe longitudinal A - A comporte un ensemble de deux électrodes, une électrode source 1' apte à être reliée à une barre de tension et une électrode de mesure du champ électrique 2' constituée d'une couche de matériau conducteur, de préférence métallique, appliquée sur une surface extérieure de l'isolateur 4' et faisant face à l'électrode source 1' le long de cet axe longitudinal A - A à une distance déterminée, l'ensemble de deux électrodes étant disposé au moins partiellement à l'intérieur d'une paroi de blindage tubulaire ouverte 3', de préférence en treillis métallique, s'étendant le long de cet axe longitudinal A - A.

L'électrode source 1' et la paroi de blindage 3' sont noyées dans un isolateur de matériau diélectrique 4', de préférence de la résine époxy ou du polyuréthane. Cet isolateur 4' est typiquement de forme tronconique ou cylindrique de section constante.

La couche de matériau conducteur 2' a une forme identique à celle 2 du premier mode de réalisation précédemment décrit.

L'électrode source 1' présente une extrémité libre faisant face à l'électrode de mesure 2' et est constituée d'une tige à extrémité demi-sphérique ou arrondie 1'A de diamètre compris entre 10% et 90% et de préférence de l'ordre d'environ 40% du diamètre de la paroi de blindage. Elle comporte également une partie 1'B de connexion mécanique et électrique à une barre de tension qui est cylindrique de de diamètre supérieure.

Cette tige 1'A est donc de longueur inférieure à celle de la tige 1 A du premier mode réalisation précédemment décrit.

Le dispositif comporte également un circuit électronique de traitement 5' électriquement connecté à la couche de matériau conducteur 2' par un élément élastique conducteur 6', constitué de préférence par un ressort hélicoïdal, dont une extrémité est en appui sur la couche de matériau conducteur 2', l'autre extrémité étant connectée à une piste adéquate du circuit électronique de traitement 5'.

Ce circuit électronique de traitement 5' est disposé dans une cavité 10' agencée dans l'isolateur 4'.

De préférence, cette cavité est cylindrique, centrée sur l'axe longitudinal A - A et disposée à l'intérieur de la paroi de blindage tubulaire 3'.

La paroi de blindage tubulaire 3' est supportée par au moins deux tenons 7' surmoulés dans l'isolateur 4', de préférence par trois tenons 7' répartis régulièrement autour de l'axe longitudinal A - A.

Le circuit électronique 5' est posé sur un support 8'A posé sur une paroi de fond d'une chambre blindée 8' en forme de cuve ouverte. Ce support 8' est de hauteur adaptée à la distance déterminée entre l'électrode source 1' et l'électrode de mesure 2'. Le ressort 6' est ainsi comprimé entre le circuit électronique 5' et la couche de matériau conducteur 2'. L'ensemble est fixé avec la chambre blindée 8' au moyen d'une vis 9' visée dans chaque tenon 7'.

La seconde chambre 8' n'est pas représentée sur la figure 3.

L'invention n'est bien sûr pas limitée aux modes de réalisation représentés et précisément décrits. Par exemple, l'électrode de mesure formée d'une couche conductrice 2, 2' peut être disposée à une autre position que celles précédemment décrites, à l'intérieur de l'élément de blindage tubulaire 3, 3'.

L'espace entre ladite chambre blindée 8, 8' et l'isolateur 4, 4' peut être rempli au moins partiellement par un matériau isolant.

## Revendications

1. Capteur capacitif s'étendant le long d'un axe longitudinal (A-A) et comportant un ensemble de deux électrodes, une électrode source (1, 1') apte à être reliée à une barre de tension et une électrode de mesure du champ électrique (2, 2') faisant face à l'électrode source le long de cet axe longitudinal (A - A) à une distance déterminée, ledit ensemble de deux électrodes étant disposé au moins partiellement à l'intérieur d'un ensemble de blindage, composé d'un élément de blindage tubulaire (3, 3') s'étendant le long de cet axe longitudinal (A-A) et d'une chambre blindée (8, 8'), l'électrode source (1, 1') étant noyée dans un isolateur (4, 4') de matériau diélectrique et ladite chambre blindée étant extérieure audit isolateur (1, 1'), capteur capacitif **caractérisé en ce que** ladite électrode de mesure est constituée d'une couche de matériau conducteur (2, 2') appliquée sur une surface dudit isolateur (4, 4').

2. Capteur selon la revendication précédente, **caractérisé en ce que** ladite couche de matériau conducteur (2A, 2'A) est de forme arrondie en section longitudinale, ladite surface de l'isolateur (4, 4') comportant une partie centrale convexe.

3. Capteur selon la revendication précédente, **caractérisé en ce que** ladite couche de matériau conducteur présente un bord (2B, 2'B) arrondi en section longitudinale, ladite partie centrale convexe de ladite surface de l'isolateur (4, 4') étant bordée d'une partie annulaire concave en section longitudinale.

4. Capteur selon l'une des revendications précédentes, **caractérisé en ce que** ladite électrode source (1, 1') présente une extrémité libre faisant face à l'électrode de mesure (2, 2') et constituée d'une tige (1 A, 1'A) de diamètre com pris entre 10 et 90% du diamètre dudit élément de blindage (3, 3').

5. Capteur selon la revendication précédente, **caractérisé en ce que** le diamètre de ladite tige (1A, 1'A) de l'extrémité libre de ladite électrode source est d'environ 40% du diamètre dudit élément de blindage (3, 3').

6. Capteur selon une des revendications précédentes **caractérisé en ce qu'**il comporte un circuit électronique de traitement (5, 5') électriquement connecté à ladite couche de matériau conducteur (2, 2').

7. Capteur selon la revendication précédente, **caractérisé en ce que** ledit circuit électronique (5) est disposé dans ladite chambre blindée (8) externe audit isolateur.

8. Capteur selon la revendication 6 ou 7, **caractérisé en ce que** ledit circuit électronique de traitement (5, 5') est électriquement connecté à ladite couche de matériau conducteur (2, 2') par un élément élastique conducteur (6, 6').

9. Capteur selon la revendication précédente, **caractérisé en ce que** ledit élément élastique (6, 6') est un ressort hélicoïdal dont une extrémité est en appui sur ladite couche conductrice (2, 2').

10. Capteur selon l'une des revendications précédentes, **caractérisé en ce que** ledit élément de blindage tubulaire est une paroi de blindage (3) noyée dans le matériau diélectrique de l'isolateur (4).

11. Capteur selon la revendication précédente, **caractérisé en ce que** ladite paroi de blindage tubulaire (3) est supportée par au moins deux tenons (7) surmoulés dans ledit isolateur.

12. Capteur selon la revendication 10 ou 11, **caractérisé en ce que** ledit circuit électronique (5') est disposé dans une cavité (10') agencée à l'intérieur de ladite paroi de blindage tubulaire (3').

13. Capteur selon la revendication précédente, **caractérisé en ce que** ladite cavité (10') est cylindrique centrée sur ledit axe longitudinal (A-A) et disposée à l'intérieur de ladite paroi de blindage tubulaire (3').

14. Capteur selon l'une des revendications 10 à 13, **caractérisé en ce que** ladite paroi de blindage tubulaire (3, 3') est en treillis métallique.
